# EUROPEAN PATENT APPLICATION

(11) **EP 2 128 689 A1**
(43) Date of publication of application: **02.12.2009**
(21) Application number: 08157028.5
(22) Date of filing: 27.05.2008
(51) Int. Cl.: G02F 1/1335, G09F 9/33, H01L 33/00

(54) **A display panel with improved reflectivity**

(71) Applicant: Barco NV, 8500 Kortrijk (BE)
(72) Inventor: Devos, Bruno, 9870 Zulte (BE); Noyelle, Katrien, 8560 Gullegem (BE); Gerets, Peter, 8800 Roeselare (BE)
(74) Representative: Bird, William Edward

(57) **Abstract**

A display or lighting element (100) comprising at least one pixel element (120) for producing or controlling light is provided. The pixel element has a light emitting surface (121). The display or lighting element furthermore comprises a substantially transparent material (150) above at least the light emitting surface. The substantially transparent material above the light emitting surface has a modified roughness so as to decrease the reflectivity of the substantially transparent material above the light emitting surface.

## Description

### Technical field of the invention

The present invention relates to display panels, such as fixed format display panels, e.g. EL panels, Plasma panels, OLED panels, LED panels or LCD panels and to a method to provide a lighting device or display panel, such as EL panels, OLED panels, Plasma panels, LED panels or LCD panels.

### Background of the invention

Fixed format display panels known in the art usually comprise an array of pixel elements for producing or controlling light over a small area, such as e.g. LED elements, OLED elements, inorganic EL-pixel elements, LCD's, E-ink or any other suitable pixel element as used in LED-displays, OLED displays, LCD displays, plasma displays, field emission displays, EL-displays, digital mirror devices, LCOS devices, lighting devices and alike. The pixel elements may be reflective, transmissive or emissive and comprise a light emitting surface at which the light is reflected, transmitted or emitted. The pixel elements often are mounted on a support.

Especially in case the display panels are to be used outdoors, hence need to be waterproof, the display panel may comprise substantially transparent potting material, covering the light emitting surfaces of the pixel elements and at least a part of the support. The potting material thus provides an optical surface of the display panel through which the image created by the pixel elements is visible.

Though the potting material may comprise a colour pigment providing a colour to the light emitted through the optical surface, the potting material is to be as transparent as possible in order to reduce the light intensity of the emitted light of the pixel element as little as possible. A disadvantage however is that the higher the light transparency of the potting material, the higher the light reflectivity of the potting material, e.g. the reflectivity for the ambient light, e.g. solar light, at its surface. Due to this reflection, the image created by the pixel elements may become disturbed, i.e. unclear. This is especially the case when images with low intensity or images with small intensity differences between adjacent pixel elements are to be made visible.

### Summary of the invention

It is an object of the present invention to provide lighting and/or display elements, e.g. good display panels or good leds, and methods of making the same, the panels optionally being for use as outdoor display panels or parts of outdoor displays. An advantage of panels according to embodiments of the present invention is that they can show less reflection of ambient light, hence allow to display images more clear under different angles of incident ambient light, even for images having a low intensity difference between adjacent pixels. Embodiments of the present invention can also provide a method for manufacturing display panels having these advantages. Such methods advantageously can be accurate, precise and without the need of complex and/or labor intensive process steps.

The above objective is accomplished by methods and display panels according to the present invention.

According to a first aspect, the present invention relates to a method for providing at least one display or lighting element, the method comprising the steps of providing at least one pixel element for producing or controlling light, the pixel element having a light emitting surface with a substantially transparent material at least above the light emitting surface, and modifying the roughness of the substantially transparent material so as to decrease the reflectivity of the substantially transparent material above the light emitting surface. The substantially transparent material may be capping material or part of a cap. The substantially transparent material may be a substantially transparent lens element being on top of the light emitting surface, whereby modifying the roughness may comprise modifying the roughness of the lens element. Modifying the roughness may comprise making the lens element at least partly opaque. Providing at least one pixel element may comprise obtaining individual ready made pixel elements, may comprise obtaining a plurality of pixel elements to be mounted on a support, e.g. a PCB substrate, or may comprise manufacturing individual pixel elements. In case a plurality of pixel elements mounted on a support are obtained, modifying the substantially transparent material may comprise modifying a lens element on a plurality or each of the pixel elements.

In one embodiment, providing at least one pixel element may comprise providing the at least one pixel element so that it is mounted on a support, e.g. providing a support and mounting the pixel element thereon. Providing a substantially transparent material furthermore may comprise providing a substantially transparent material also over at least a part of the support thereby providing an optical surface having at least one pixel element zone and at least one support zone, wherein the pixel element zone is a part of the optical surface above the light emitting surface and the support zone is a part of the optical surface not above a light emitting surface and wherein modifying the roughness of the substantially transparent material is adapted for rendering the pixel element zone of the optical surface equally or more rough than the support zone of the optical surface. The at least one display or lighting element may be a display panel. Providing a substantially transparent material therefore may comprise providing a substantially transparent material on a portion of the support positioned adjacent the light emitting surface.

The pixel element zone may be defined as the part of the optical surface that is bound by the projection of a light emitting surface of a pixel element onto the optical surface in an average emission direction with respect to the optical surface. The pixel element zone may be defined as the part of the optical surface that is outside a projection of a light emitting surface of a pixel element onto the optical surface in an average emission direction with respect to the optical surface.

"Reflectivity" is to be understood as referring to specular reflection. Specular reflection may be measured by detecting incident radiation at an angle of the same magnitude but opposite to the incident angle with respect to the normal to the surface. The methods and devices according to embodiments of the present invention have the advantage that the specular reflection may be reduced. Some or all of the incident ambient light may be reflected as diffuse light, which however does not negatively influence the sharpness of the images display on the display panels to a too large extent.

The support may be a PCB board to which the pixel elements can be coupled.

This method has the advantage that, due to the roughened surface of the substantially transparent material, i.e. at the pixel element zone or at the cap or lens above the light emitting surface, i.e. at the zones of the optical surface under which the light-emitting surface of a pixel element is present, the reflectivity of the optical surface is reduced.

Incident light from e.g. ambient light such as solar light can be reflected in a more diffuse way. As a result, for given ambient conditions and given light intensity emitted by the pixel element or elements, the ratio of the amount of emitted light of the pixel elements over the amount of reflected ambient light (this ratio is also known as contrast ratio) is increased. As a further result, the difference in light emissions of adjacent pixels can become more obvious and noticeable for the user under given ambient light conditions.

If transparent material is applied to a support as well, at the zone of the optical surface under which no light emitting surface of a pixel element is present, the reflectivity of the optical surface may be changed as well.

Although by roughening the optical surface at the pixel element zone or zones, the cap or the lens element, the image sharpness might be reduced, it was found that by roughening the substantially transparent material, and optionally roughening the support zones, if present, in an identical or similar way, the image quality is influenced more positively by the increase of the contrast ratio in comparison with a possible negative influence of sharpness reduction. This also applies in case images with low intensity or images with small intensity differences between adjacent pixel elements are to be made visible. This effect is in particular true for display panels with a low pitch, e.g. a pitch of about 2.5 mm to 5 mm.

The method can enable the use of substantially transparent or translucent materials, e.g. potting materials having relatively high optical transmissivity thus avoiding severe reduction of the light intensity of the emitted light of the pixel element passing through the substantially transparent or translucent materials, e.g. potting material. Alternatively the substantially transparent or translucent materials also may be cap material or lens material. The method solves at least partially the disadvantage of high reflectivity of these materials having high optical transmissivity. Optionally however, the substantially transparent or translucent materials may comprise absorbers, for absorbing some of the emitted light intensity. This is in particular the case when the light illuminating elements would emit a too large light intensity for the application for which the lighting or display element, e.g. display panel, is to be used.

As the method does not require adding additional material to the optical surface, but changes locally the reflective properties of the substantially transparent or translucent materials, e.g. potting material, at the optical surface, the display panel has a lower risk on loosing its properties over time due to weather conditions and/or environmental conditions. It also enables the use of translucent or transparent materials, which are less suitable, hardly suitable or even not suitable to add additional material to, such as e.g. silicon or silicon-base material. Alternatively, additional material still may be added to the optical surface in order to tune the optical surface.

The display panel may be provided in different dimensions and shapes, and the method benefits of having substantial no dimensional restrictions.

The display panel may comprise a multitude of frame parts, each frame part being provided with a support for supporting one but usually more than one pixel element such as LEDs, OLEDs or LCD's, E-ink pixels, possibly all aligned and/or arranged in a matrix. The different frame parts may be coupled to each other along one or more coupling elements of the frame.

The support may have a substantially rectangular, oval, circular or other geometrical shape, on which a multitude of pixel elements are arranged, possibly according to a pixel element array.

The substantially transparent or translucent material can be a potting material. Any suitable potting material may be used. Optionally the potting material is a material out of the group of polyurethane polymers, silicone-based materials, epoxy resin and acrylate polymers. The substantially transparent or translucent material also may be a capping material. The substantially transparent or translucent material also may be lens material.

The substantially transparent or translucent material may be a substantially transparent or translucent foil or plate, such as e.g. a substantially transparent or translucent polycarbonate or acrylate foil or plate. The substantially transparent or translucent material may be any suitable material for providing a layer that is substantially transparent or translucent, e.g. by means of potting, hot-melting, spraying lacquering or gluing. Substantially transparent or translucent materials may be substantially transparent or translucent thermo-hardening material, polypropylene, polyethylene, polycarbonate PMMA or suitable acrylates. The transparent or translucent material also may be applied in the form of a cap or lens element.

The transparent or translucent material, e.g. in the form of a potting material, preferably is applied to the light emitting surfaces of the at least one light emitting element and to at least a part of the support in any suitable way. The transparent or translucent material may also be applied to a single pixel element, for covering the light emitting surfaces of the single pixel element and optionally also at least a part of the support. The transparent or translucent material, e.g. in the form of a potting material, cap material or lens material, provides the optical surface of the display or lighting element, e.g. display panel, which surface can be substantially flat, i.e. having a relatively smooth or even surface. Optionally the optical surface at the transparent or translucent material where light is coupled out may be curved, e.g. slightly curved, to prove a lens-effect above the light emitting element. The transparent or translucent material, e.g. in the form of a potting material, cap material or lens material, may be provided at each point of the display or lighting element, e.g. display panel, where it is present in such a way that it has a substantially uniform thickness over the optical surface. In this way the surface of the transparent or translucent material, may not necessarily be substantially flat, but the pixel element zones will extend beyond the support zones.

According to some embodiments of the present invention, the method may comprise the step of modifying the roughness of the substantially transparent material in a support zone. Such a support zone may be a portion of the support where no pixel element is present.

According to some embodiments of the present invention, the step of modifying the roughness of the substantially transparent material in the support zone may comprise the step of roughening of the substantially transparent material in the support zone.

Modifying the roughness of the substantially transparent material of the optical surface and along the support zone of the optical surface may be done in one and the same step, or may be done during different steps. The roughness provided to the substantially transparent material of the optical surface and along the support zone of the optical surface may be identical or different, both in roughness as well as in the method to provide the roughness.

According to some embodiments of the present invention, the step of modifying the roughness of the substantially transparent material, e.g. in the pixel element zone, may comprise the step of roughening the substantially transparent material , e.g. along the pixel element zone.

According to some embodiments of the present invention, the roughening of the substantially transparent material, e.g. of potting material, capping material or lens material, may be done by removing a part of the substantially transparent material thereby providing a regular or irregular surface pattern.

According to some embodiments of the present invention, the pattern may be a regular pattern.

Regular pattern may be e.g. substantially parallel lines, or two sets of substantially parallel lines, mutually crossing each other and forming a textile-like, woven pattern.

The advantage of the provision of a regular pattern is that it allows to adjust the reflectivity of the substantially transparent or translucent materials, e.g. potting material, capping material or lens material, e.g. at support zones as function of the angle of incidence of the incident ambient light.

According to some embodiments of the present invention, removing a part of the substantially transparent material at the optical surface may be done by irradiating the substantially transparent material at the optical surface with a laser, e.g. by laser ablation. According to some embodiments of the present invention, radiation of a CO₂-laser may be used to irradiate the substantially transparent material at the optical surface.

The irradiation may cause the irradiated, substantially transparent or translucent materials, e.g. irradiated potting material, capping material or lens material, to become partially destroyed and removed. In particular laser surface processing may be used. Laser processing has the advantage that the surface may be etched while not thermally degrading the material underneath. Laser techniques for modifying the surface include laser ablation and/or laser etching.

Using a laser to remove substantially transparent or translucent materials, e.g. potting material, lens material or capping material also has the advantage that a pattern, be it a regular or irregular pattern, may be provided in a very accurate and precise and relatively easy way. The process step may be automated e.g. computer controlled. The method allows also the precise location of the zones to be roughened, the zones which are to be left unaffected, and the degree of roughening at precise location.

The use of a laser does not create a substantial amount of particles which may be left at the surface although it allows removal of particulate matter of the substantially transparent or translucent materials, e.g. potting material, at the optical surface due to evaporation and/or thermal degradation. By selection of the laser, e.g. wavelength of light intensity used, and setting the laser processing parameters such as the use of continuous or pulsed laser light, the laser fluence etc., the etch depth and also the conversion of molecules of the potting material, capping material or lens material e.g. polymer molecules, into gaseous products such as CO₂, CO, H₂O etc. can be controlled. Hence no negative influence of the products used or created during the process needs to be taken into account during roughening. The methods can be automated and made highly efficient and have substantially no dimensional limitations. If necessary, also additional parts of the display panel, such as sides of the frame holding the support, the shading device, the pixel elements and the substantially transparent or translucent materials, e.g. the potting material, capping material or lens material may be processed, e.g. roughened, by using laser irradiation, providing a uniform roughened surface, possibly patterned, all along the outer surface of the display panel. These frames, or alternatively frame parts mounted together to form a frame, may be provided from polymer, metal such as aluminum or any other suitable material. The frame or frame parts are optionally provided with a dark colour, usually black.

According to some embodiments of the present invention, the at least one pixel element may be at least one LED. The LED or LEDs may be surface mounted light emitting devices or LEDs. The display panel may comprise at least two pixel elements, each emitting a different colour.

According to some embodiments of the present invention, the substantially transparent material may be a potting material, capping material or lens material selected out of the group of polyurethane polymers, silicone-based materials, epoxy resin and acrylate polymers.

The substantially transparent or translucent materials, e.g. potting material, capping material or lens material may be provided to the light emitting surfaces of the at least one light emitting element. It can be provided to the individual pixel elements or to a plurality of pixel elements, e.g. mounted on a support.

In some embodiments where a support is used, optionally the substantially transparent or translucent materials may also be provided on at least a part of the support. In some embodiments, providing substantially transparent or translucent materials may be performed for covering the light emitting surfaces of the at least one light emitting element and at least a part of the support, after the support and the pixel elements are mounted in a frame or in a frame part. Alternatively, the substantially transparent or translucent materials, especially in case of use of potting material, may be provided to the light emitting surfaces of the at least one pixel element and at least a part of the support, prior to mounting the support and the pixel elements into the frame or into the frame part. As an other alternative, the transparent or translucent material may already be present on the top of the pixel element, e.g. as cap or lens. Similarly, the roughened zones of the substantially transparent or translucent materials, which roughened zones provide the optical surface along the support zones, may be made prior or after mounting the support, pixel elements and substantially translucent transparent materials, in the frame or frame part. Similarly, the roughened zones of the substantially transparent or translucent materials, e.g. potting material, which roughened zones provide the optical surface along the pixel element zone and optionally the support zone, may be made prior or after mounting the support and pixel elements covered with potting materials, in the frame or frame part.

According to embodiments of the method, radiation from a gas laser such as CO₂-laser may be used to irradiate the substantially transparent or translucent material, e.g. potting material, capping material or lens material for providing the optical surface along the pixel element zone and optionally the support zone.

It was found that the use of a CO₂-laser may roughen the optical surface over a depth of about 10µm, whereas little or no modification, e.g. cutting, deeper into the substantially transparent or translucent material, e.g. potting material, was noticed. Alternatively a YAG-laser may be used.

The method has the advantage that no additional material needs to be applied, i.e. added, onto the optical surface to reduce the reflection of the optical surface at zones, which zones are accurately to be positioned. Hence weather or environmental conditions have few or even no effect on the roughened character of the optical surface, thus providing long lasting and substantially constant reflective properties of the potting material. Alternatively, additional material may be provided, e.g. for tuning the optical surface shape, and the modification of the roughness may be made into the additional material.

Also other means may be used to roughen or create matte support zones of the optical surface, such as etching, mechanical grinding, blasting, scratching, water jet treatment, grinding, brushing, and alike.

It is understood that more than one layer of substantially transparent material, such as a first layer of substantially transparent material encapsulating the light emitting surface of the pixel element, and a second substantially transparent material so as to provide the optical surface through which the light outcoupling from the pixel element occurs, may be used.

The substantially transparent material may be at least partly part of a capping portion and the pixel element zone may be the portion of the capping facing away from the light emitting surface. The substantially transparent material may be potting material in the regions above the support zone where no light emitting surface is present and capping material being a portion of the capping in the region where a light emitting surface is present. The method furthermore may comprise mounting the at least one light emitting element on the support.

The invention in a second aspect relates to display elements obtainable by the use of the method according to embodiments of the first aspect of the present invention.

According to a third aspect of the present invention, a display or lighting element comprising at least one pixel element for producing or controlling light is provided. The pixel element has a light emitting surface. the display or lighting element furthermore comprising a substantially transparent material above at least the light emitting surface, wherein the substantially transparent material has a modified roughness so as to decrease the reflectivity of the substantially transparent material above the light emitting surface. The substantially transparent material may be capping material or part of a cap. The substantially transparent material may be a substantially transparent lens element being on top of the light emitting surface. In other words, the lens may have a modified roughness. The lens element may be made at least partly opaque. The at least one pixel element may be an individual pixel element or a set of individual pixel elements. Alternatively an individual pixel element or a set of pixel elements may be mounted on a support, e.g. a PCB substrate.

The display panel thus further may comprise a support for supporting the at least one pixel element, whereby the substantially transparent material also is provided over at least a part of the support thereby providing an optical surface of the display panel having at least one pixel element zone and at least one support zone, wherein a pixel element zone is a part of the optical surface above the light emitting surface and the support zone is a part of the optical surface not above a light emitting surface and wherein the substantially transparent material may have a modified roughness adapted for rendering the substantially transparent material in the pixel element zone equally or more rough than the substantially transparent material in the support zone. The optical surface along the pixel element zone of the optical surface may be roughened for reducing the reflectivity of the optical surface along the pixel element zone.

A display or lighting element according to embodiments of the present invention has the advantage that, due to the roughened surface above the light emitting surface, i.e. at the zones of the optical surface under which the light emitting surface of a pixel element is present, the reflectivity is reduced, e.g. compared to a non-roughened surface. When a support zone is present, the reflectivity at the pixel element zone may be smaller than the reflectivity at the support zone.

Incident light from e.g. ambient light such as solar light is reflected in a more diffuse way. As a result that, for a given ambient condition and given light intensity emitted by the pixel element or elements, the contrast ratio may be increased. As a further result, the difference in light emissions of adjacent pixels becomes more obvious and noticeable under given ambient light condition.

At the zone of the optical surface under which no light emitting surface of a pixel element is present, the reflectivity of the optical surface may be changed as well.

Although by roughening the optical surface at the pixel element zone or zones, at the cap or caps or at the lens or lenses, the image sharpness might be reduced, it was found that by roughening the substantially transparent or translucent material at pixel element zones, caps or lenses, and optionally roughening the substantially transparent or translucent material at support zones in an identical or similar way, the image quality is influenced more positively by the increase of the contrast ratio in comparison with the negative influence of sharpness reduction. This also applies in case images with low intensity or images with small intensity differences between adjacent pixel elements are to be made visible. This effect is in particular true for display panels with a low pitch.

The substantially transparent or translucent materials, e.g. potting materials or capping materials or lens materials, preferably having a high optical transmissivity which may be used in order to avoid reduction of the light intensity of the emitted light of the pixel element passing through the substantially transparent or translucent material, e.g. potting material, capping material or lens material, whereas at least partially the disadvantage of high reflectivity of these materials having high optical transmissivity is compensated.

It may be an advantage of embodiments of the present invention that no additional material needs to be added or fixed to the optical surface, but the properties of the substantially transparent or translucent material, e.g. potting material is changed locally at the optical surface, i.e. at the pixel element zone or zones and optionally at the support zone or zones, the display panel has a lower risk on loosing its properties over time due to weather conditions and/or environmental conditions. Hence weather or environmental conditions have few or even no effect on the roughened character of the optical surface, which provided long lasting and substantially constant reflective properties of the substantially transparent or translucent material, e.g. potting material. Alternatively additional material may be added and the modified roughness may be provided at the surface of the additional material.

It is understood that more than one layer of substantially transparent material, such as a first layer of substantially transparent material encapsulating the light emitting surface of the pixel element, and a second substantially transparent material so as to provide the optical surface of the through which the light outcoupling from the pixel element occurs.

According to some embodiments of the present invention, the substantially transparent material in the support zone, the cap or the lens may be roughened.

According to some embodiments of the present invention, the substantially transparent material of the optical surface may be roughened by providing a regular or irregular surface pattern to the substantially transparent material of the optical surface. According to some embodiments of the present invention, the pattern may be a regular pattern.

According to some embodiments of the present invention, the substantially transparent material of the optical surface may be roughened by removing a part of the substantially transparent material at the optical surface by irradiating the substantially transparent material at the optical surface with a laser. According to some embodiments of the present invention, radiation of a CO₂-laser may be used to irradiate the substantially transparent material at the optical surface.

According to some embodiments of the present invention, the at least one pixel element may be at least one LED.

According to some embodiments of the present invention, the substantially transparent material may be a potting material. The substantially transparent material may at least partly be a capping material. In some embodiments where a support is present, the substantially transparent material may be a capping material in the pixel element zone and potting material in the support zone. The substantially transparent material may at least partly be a lens material.

The display or lighting element, e.g. display panel, may further comprise additional element such as shaders or a shading device, provided between adjacent pixel elements. The shading device may comprise a plurality of louvers or shading elements, e.g. for shading pixel elements of the display panel from incident angled light, i.e. light hitting the display system under predetermined angles, or from cross-talk from neighbouring pixel elements. It is understood that the transparent material may cover the shaders or shading device completely, e.g. the louvers being sunk in the transparent material, or that parts of the shading device, e.g. parts of the louvers, extend above from the optical surface of the display panel.

The display or lighting element, e.g. display panel or individual display element, may be provided in different dimensions and shapes, having substantial no dimensional restrictions.

The display or lighting element, e.g. display panel, may comprise a multitude of frame parts, each frame part being provided with a support for supporting one but usually more than one pixel element. The pixel elements may be suitable for EL, LED, OLED or LCD displays or illumination purposes. The different frame parts may be coupled to each other along one or more coupling elements of the frame.

The support may have a substantially rectangular, oval, circular or other geometrical shape, on which a multitude of pixel elements are arranged, possibly according to a pixel element array.

The substantially transparent or translucent material, may be a potting material such as any suitable potting material. Optionally the potting material is a material out of the group of polyurethane polymers, silicone-based materials, epoxy resin and acrylate polymers.

The substantially transparent or translucent material may be a substantially transparent or translucent foil or plate, such as e.g. a substantially transparent or translucent polycarbonate or acrylate foil or plate. The substantially transparent or translucent material may be any suitable material for providing a layer that is substantially transparent or translucent, e.g. by means of hot-melting, spraying lacquering or gluing. Substantially transparent or translucent materials may be substantially transparent or translucent thermo hardening material, polypropylene, polyethylene, polycarbonate, PMMA or other suitable acrylates. It may be a material that is suitable for forming a cap or lens.

The potting material, capping material or lens material advantageously may provide the optical surface of a display or lighting element, e.g. a display panel, which surface can be substantially flat, i.e. having a relatively smooth or even surface. The potting material, capping material or lens material may be provided at each point of the display panel where it is present in such a way that it has a substantially uniform thickness over the optical surface. In this way the surface of the potting material may not necessarily be substantially flat. In case pixel elements on a support are used, the pixel element zones may extend beyond the support zones.

According to embodiments of the present invention, the substantially transparent or translucent material, e.g. potting material, lens material or capping material of the optical surface above the light emitting surface, and optionally along the support zone, of the optical surface may be roughened by providing a regular or irregular surface pattern to the substantially transparent or translucent material, e.g. potting material, capping material or lens material of the optical surface.

According to embodiments of the present invention, the pattern may be a regular pattern.

The advantage of the provision of a regular pattern is that it allows adjusting the reflectivity of the substantially transparent or translucent material, e.g. potting material, capping material or lens material at the optional support zones as function of the angle of incidence of the incident ambient light.

According to embodiments of the present invention, the substantially transparent or translucent material, e.g. potting material, capping material or lens material of the optical surface above the light emitting surface, and optionally along the support zone of the optical surface, may be roughened by removing a part of the substantially transparent or translucent material, e.g. potting material, capping material or lens material at the optical surface by irradiating the substantially transparent or translucent material, e.g. potting material, capping material or lens material at the optical surface along the pixel element zone and optionally also along the support zone with a laser.

According to embodiments of the present invention, radiation of a gas laser such as a CO₂-laser may be used to irradiate the substantially transparent or translucent material, e.g. potting material, capping material or lens material at the optical surface. It was found that the use of a CO₂-laser roughens the optical surface over a depth of about 10µm, whereas less to no cutting deeper into the substantially transparent or translucent material, e.g. potting material, capping material or lens material was noticed. Typically a laser printing device may be used. When the roughening is provided by means of laser irradiation, typically a number of lines or dots per inch or square inch can be noticed in the pattern, even in irregular patterns.

According to embodiments of the present invention, the at least one pixel element may be at least one LED. The display or lighting element may be a display panel comprising a plurality of pixel elements, such as a plurality of LED's, which LED's may be all of the same colour or may provide illumination of different colours

The display or lighting element, e.g. display panel may comprise additional elements such as a frame or frame parts mount together, on or in which the support and the pixel elements are mounted. If necessary, also additional parts of the display or lighting element, e.g. display panel, such as sides of the frame holding the support and the pixel elements with the potting material, capping material or lens material may be roughened by using laser irradiation, providing a uniform roughened surface, possibly patterned, all along the outer surface of the display or lighting element, e.g. display panel. These frames, or alternatively frame parts mounted together to form a frame, may be provided from polymer, metal such as aluminium or any other suitable material. The frame or frame parts are optionally provided with a dark colour, usually black.

According to some embodiments of the present invention, the display or lighting element may be an outdoor display panel.

The panel can be environmentally protected, e.g. sealed against ingress of water.

According to some embodiments of the present invention, the display or lighting element may be part of an LED panel. The LED panel may be a power LED panel.

According to some embodiments of the present invention, the display or lighting element may be part of a signal, such as a traffic signal or traffic lights.

According to some embodiments of the present invention, the display or lighting element may be part of a lighting apparatus.

According to some embodiments of the present invention, the display or lighting element may be part of a display.

The display or lighting element, e.g. display panel, may comprise a plurality of pixel elements. The pitch between the pixel elements may be in the range of 2.6mm to 20mm, e.g. 4.5mm. In a monochromatic display element, the pitch is the average distance between adjacent pixel elements. In a multicolour display panel, the pitch is the average distance between the geometric centres of adjacent groups of pixel elements, which group of pixel elements is able to emit the multicoloured light of the display panel.

It is understood that the display or lighting element may be a flat panel display. However it is understood that such flat panel display does not have to be exactly flat but includes shaped; bent or bendable panels. A flat panel display differs from display such as a cathode ray tube in that it comprises a matrix or array of pixel elements, also often referred to as cells or pixels, each producing or controlling light over a small area. There is a relationship between the pixel of an image to be displayed and pixel element of the display. Usually this is a one-to-one relationship. Each pixel element may be addressed and driven separately. It is not considered a limitation on the present invention whether the panel displays, in particular the flat panel displays, are active or passive matrix devices. The array of pixel elements may be in rows and columns but the present invention is not limited thereto but may include any arrangement, e.g. polar or hexagonal.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved display panels according to embodiments of an aspect of the present invention. The displays benefit from the reduced reflectivity and/or show longer life times and/or can be used substantially independently of the amount and direction of ambient incident light, still allowing to make clear and undisturbed image visible, even in case the images have pixel intensities varying only slightly between adjacent pixels. In particular the display panels may have a short pixel pitch, i.e. adjacent pixel elements are positioned closely one relative to the other. The displays can also be made liquid tight, e.g. water tight, hence can be used as outdoor displays.

According to another aspect of the present invention, it is an object to provide good apparatus or methods for displaying color images or do color lighting, e.g. displaying full color images or do full color lighting. It is an advantage of embodiments according to the present invention that a good viewing angle dependency for optical properties, e.g. individual color emission can be obtained. The dependency of individual color emission on the viewing angle can be controlled or even tuned. It is an advantage of embodiments according to the present invention that lensing effects for individual pixel elements, e.g. LED's, may be reduced or tailored.

The present invention therefore also relates to a display or lighting element for emitting light, the display or lighting element, which also may be referred to as light source, comprising at least one light emitting surface and first encapsulation material encapsulating said at least one light emitting surface, the display or lighting element further comprising a second encapsulation material so as to obtain a modified surface of the encapsulation through which the light outcoupling from the light source occurs.

It is an advantage of embodiments of the present invention that the optical properties of the light coupled out, such as colour or intensity, is less sensitive to variation in the viewing angle.

The modified surface of the encapsulation through which the light outcoupling from the light source occurs may be adapted so as to tune optical properties as function of viewing angle. The modified surface of the encapsulation may be substantially flat surface. Such a surface may have roughness or variations from a plane smaller than 20% of the length of a characteristic length such as a diameter of the light emitting surface, advantageously smaller than 10%, more advantageously smaller than 5%, even more advantageously smaller than 1 %, still more advantageously smaller than 0.2%. The modified surface may be adapted to substantially maintain the colour output for viewing angles within the range -30° to 30°, advantageously within the range -40° to 40°, more advantageously within the range -50° to 50°, even more advantageously within the range -60° to 60°.

The at least one light emitting element may comprise at least two light emitting elements each emitting a different colour.

The light source may be a surface mounted light emitting device. The first encapsulation material may have a larger shrink than that of epoxy when solidified or a larger thermal expansion coefficient than that of epoxy at its solidification temperature.

At least the first encapsulation material may be a silicone.

The surface of the first encapsulation material may be curved, e.g. concave.

The features of the present aspects may be applied to a lighting or display element as described in the other aspect of the present invention. For example, the modification of the surface roughness of the substantially transparent material, may be a modification of the surface roughness of the second encapsulant material of a lighting or display element as described in the present aspect.

The present invention also relates to a display, lighting or imaging system comprising a light source as described above.

The present invention also relates to a method for altering a light source, the method comprising obtaining a light source with at least one light emitting element and a first encapsulation material, and providing a second encapsulation material thus modifying the surface of the encapsulation through which the light outcoupling from the light source occurs.

Providing a second encapsulation material may comprise providing a second encapsulation material so as to obtain a substantially flat surface of the encapsulation.

Providing a second encapsulation material may comprise providing a second encapsulation material so as to tune the optical properties of the light source as function of the viewing angle.

Providing a second encapsulation material may comprise providing a predetermined amount of second encapsulation material so as to modify the surface of the encapsulation through which the light outcoupling from the light source occurs and thus tune the optical properties of the light source as function of the viewing angle.

Providing a second encapsulation material may comprise providing second encapsulation material to a predetermined position on the original encapsulation material so as to modifying the surface of the encapsulation through which the light outcoupling from the light source occurs and thus tune optical properties of the light source as function of the viewing angle.

Obtaining a light source comprises obtaining a light source with a first encapsulation material having a larger shrink than that of epoxy when solidified or with a larger thermal expansion coefficient at its solidification temperature than epoxy. Obtaining a light source may comprise obtaining a light source with a first encapsulation material being a silicone.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Fig. 1a is a top view of a display panel according to an embodiment of the present invention.
Fig. 1b is a cross section according to plane AA' of the display panel shown in Figure 1a.
Fig. 2 shows schematically some different patterns, which may be provided to the support zones of the optical surface of the display panel of Fig.1a, and Figure 1b or Figure 3a or Figure 3b.
Fig. 3a is a top view of an alternative display panel according to an embodiment of the present invention.
Fig. 3b is a cross section according to plane AA' of the display panel shown in Figure 3a.
FIG. 3c and FIG. 3d illustrate a display or lighting element being a led with a modified surface roughness in the capping material respectively lens above the light emitting surface.
Fig. 4a is a top view of an alternative display panel according to an embodiment of the present invention.
Fig. 4b is a cross section according to plane AA' of the display panel shown in Figure 4a.
Fig. 4c is a cross section according to plane AA' of a display panel wherein no additional potting material is used, as can be obtained using a method according to the present invention.
Fig. 5 illustrates an example of a light source with first and additional encapsulation material according to an embodiment of the present invention.
Fig. 6 illustrates the just noticeable difference as function of viewing angle for an originally filled LED without additional encapsulation material and for an additionally filled LED having flat surface, according to an embodiment of the present invention.
Fig. 7a and Fig. 7b both illustrate the spreading in colour coordinates obtained for an originally filled LED without additional encapsulation known from the prior art and a LED with additional encapsulation material according to an embodiment of the present invention.
Fig. 8 illustrates the experienced colour for different viewing angles for a white image shown

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

The optical surface is to be understood as the surface of the display panel on which an image is created by the light emitted by using the pixel elements.

The term "pixel element" is to be understood as the smallest addressable element on a display panel. The pixel element provides the basic unit of the composition of an image on such display panel. The pixel element produces light to be emitted or controls light, i.e. a light beam, thereby directing or redirecting the light beam using its light reflective or light transmissive properties. A pixel element hence may be emissive, reflective or transmissive.

The term "substantially transparent or translucent" is to be understood as having the property of being transparent, that is of transmitting light without appreciable scattering so that bodies lying beyond are seen clearly.

The term "light emitting surface" of a pixel element is the surface of the pixel element which emits the produced or controlled light beam.

The term "roughening" according to the present invention should be interpreted broadly and includes providing a surface marked by inequalities, protrusions, recesses, ridges, or projections etc. A surface may be roughened by addition or subtraction of material.

The term "potting material" means an insulating or protective material used to embed electronic components in a container or on a surface of a supporting structure. The term "capping material" means an insulating or protective material used as material for a cap having an insulating and/or protective function with respect to the light emitting surface for an individual pixel element, e.g. led. The term "lens material" means material used for a lens, which in the present application may be positioned on top of the light emitting surface in order to couple out the light of the light emitting surface.

The term "optical transmissive" and "optical transmissivity" relates to devices of materials suitable to transmit visible light.

The term "polishing" is to be understood as smoothening the surface by any suitable means.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

According to one aspect, the present invention relates to a display or lighting element. The display or lighting element thereby comprises at least one pixel element for producing or controlling light. The display or lighting element therefore may be an individual pixel element, such as for example a led, a set of individual pixel elements, not in a mounted state, an individual pixel element mounted on a support or a set of individual pixel elements mounted on a support, e.g. a display panel. The at least one pixel element comprises a light emitting surface. The display or lighting element furthermore comprising a substantially transparent material above at least the light emitting surface. The substantially transparent material may be capping material of a cap being present, lens material of a lens being present or potting material by which the light emitting surface may be embedded. The substantially transparent material has a modified roughness so as to decrease the reflectivity of the substantially transparent material above the light emitting surface. In some embodiments, the cap may have such a modified roughness. In some embodiments, the lens element may have such a modified roughness. In some embodiments potting material may have a modified roughness. By way of illustration, the present invention not being limited thereto, a plurality of examples are provided.

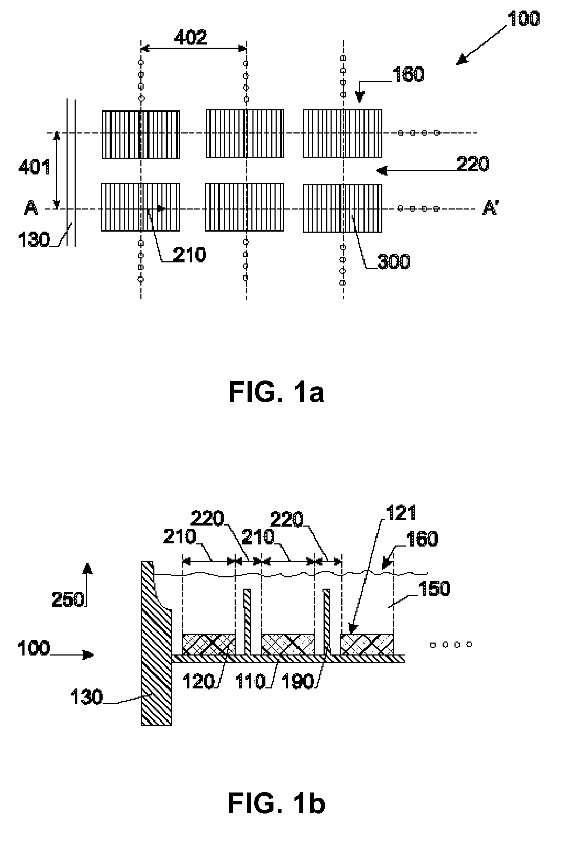

In one example the display or lighting element may be a display panel or part of a display or display assembly. A display or display assembly comprises a display panel 100, an example thereof being shown in Figure 1a and Figure 1b. The display panel as shown comprises a plurality of matrix-aligned pixel elements 120 for producing or controlling light. In this particular embodiment LED's are mounted. The present invention may be used with any suitable pixel element, e.g. an LCD pixel element, an EL pixel element, Plasma pixel element, an OLED pixel element, etc. Each pixel element 120 has a light emitting surface 121. The pixel elements 120 are mounted on a support 110, being e.g. a PCB board to which the pixel elements 120 are coupled. A substantially transparent material 150 advantageously is provided on top of and between the pixel elements 120. In some embodiments, the support 110 carrying the pixel elements 120, may be mounted in a frame part 130. The frame part 130 advantageously may form an elevated collar around the support 110, whereby the volume defined by the frame part 130 and support 110 may be filled with substantially transparent material 150.

The substantially transparent material 150 may be a potting material such as substantially transparent or translucent polyurethane or silicone. The pixel elements 120 thus are embedded in and their light emitting surface 121 is covered with potting material 150. The optical surface 160 may be provided as a substantially flat surface. Alternatively the optical surface may for example be curved in front of the light emitting element, in order to create a lens-effect.

The substantially transparent material 150, e.g. potting material, covers the light emitting surfaces 121 of the pixel elements 120 and the support 110 thereby providing the optical surface 160 of the display panel 100.

The display panel may further comprise a shader device 190 which in this embodiment is embedded in the potting material as well.

As shown in Fig. 1a, the optical surface 160 comprises a plurality of pixel element zones 210, one for each pixel element 120. A support zone 220 encompasses the pixel element zones 210. As shown in the cross-section according to the plane AA' in Fig. 1b, a pixel element zone 210 is a part of the optical surface 160 bound by the projection of a light emitting surface 121 of a pixel element 120 onto the optical surface 160 in a direction 250 perpendicular to the optical surface 160. A support zone 220 is a part of the optical surface 160 bound by the projection of the support 110 onto the optical surface 160 in a direction 250 perpendicular to the optical surface 160.

The light emitting elements may be mounted non-perpendicularly to the optical surface 160, but may be oriented under a small angle vis-à-vis the direction perpendicular to the optical surface, towards a given intended observation direction. This to improve the visibility of the image to be displayed on the display panel in case the images are intended to be observed under the observation direction.

The substantially transparent or translucent material 150 of the optical surface 160 along the pixel element zone 210 of the optical surface is modified, in this case made more rough than the substantially transparent or translucent material 150 of the optical surface 160 along the support zone 220 of the optical surface.

According to an example of one particular embodiment, the substantially transparent material 150 of the optical surface 160 along the pixel element zone 210 of the optical surface 160 is roughened, e.g. according to a pattern 300. In the present example, the optical surface is roughened according to a regular pattern consisting of substantially parallel lines. As the roughness of the optical surface 160 along the pixel element zone 210 of the optical surface 160 is modified, there is a difference in roughness between the support zone 220 and the pixel element zone 210, i.e. the optical surface 160 at pixel element zone 210 is more rough than at the support zone 220.

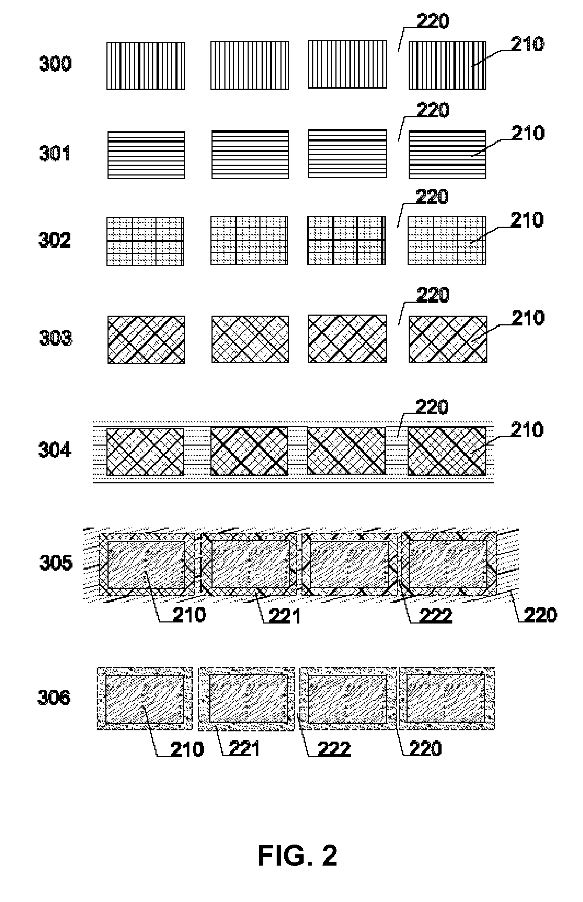

Fig. 2 shows some alternative patterns, which are suitable for roughening the optical surface 160 at the support zone 220. Patterns 300 and 301 are regular pattern consisting of substantially parallel lines. Pattern 302 is a combination, i.e. a superposition, of the patterns 300 and 301. Pattern 302 comprises two sets of mutually substantially parallel lines, mutually crossing each other and forming a textile-like, woven pattern. Pattern 303 is a variant of pattern 302, wherein the two sets of mutually substantially parallel lines are inclined over an angle of substantially 90° with regard to the direction along which the eight pixel elements are aligned. Pattern 304 is still an other alternative pattern, where the pixel element zone are roughened using the same pattern as in 303, but where the support zone 220 is roughened, to a less extend, using a regular pattern consisting of substantially parallel lines.

Yet another pattern 305 uses a random, irregular pattern of elevations and valleys over the pixel element zone 210 of the optical surface 160. The support zone 220 comprises areas 221 encompassing the pixel element zones, which are roughened to a less extent as compared to the pixel element zones 210, using a regular pattern consisting of two perpendicularly oriented pairs of substantially parallel lines. The remaining area 222 of support zone 220 is roughened to a lesser extend as areas 221, using a regular pattern consisting of substantially parallel lines.

Yet another pattern 306 uses a random, irregular pattern of elevations and valleys over the pixel element zone 210 of the optical surface 160. The support zone 220 comprises areas 221 encompassing the pixel element zones, which are roughened identically as the pixel element zones 210. The remaining area 222 of support zone 220 is not modified, hence not roughened.

The skilled person understands that other combinations of random patterns, irregular patterns and regular patterns may be used to roughen the pixel element zones and optionally parts or the complete support zone.

Turning to figures 1a and 1b, as an example the display panel is a monochromatic display panel comprising a plurality of LEDs 120, having a pitch of e.g. 4.5 mm one to the other. The pitch is the average centre-to-centre distance of adjacent pixel elements. In this embodiment, this is the average of the distances 401 and 402. Though an example is given of an irregular array of pixel elements, it is understood that a regular array of pixel element may be provided and used.

The accumulated surface of the pixel element zones represents about 50% of the optical surface, e.g. 50% of the optical surface.

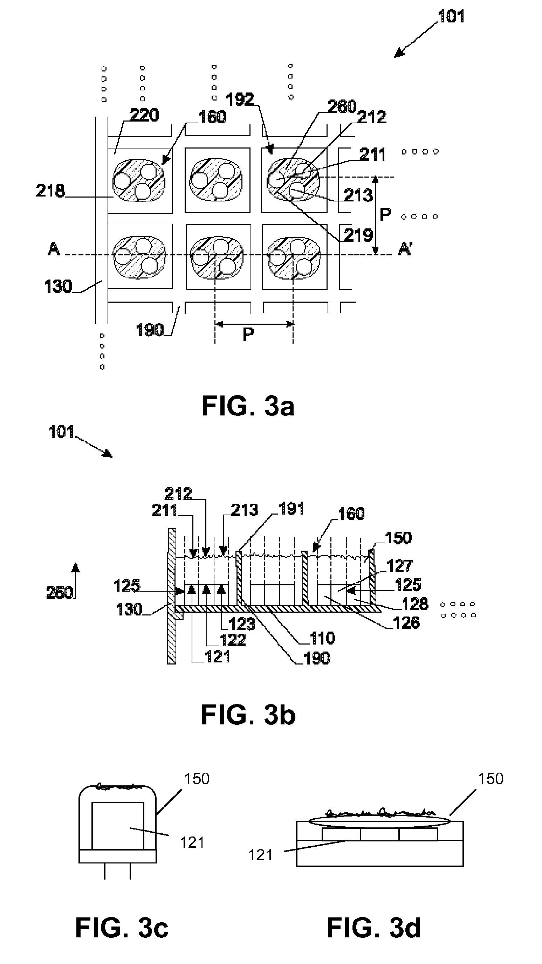

An alternative, multicolour display panel 101 is shown in Figure 3a and Figure 3b. Identical references refer to similar features as set out in relation to the display panel 100 of Figure 1 a and Figure 1 b.

The display panel comprises a plurality of matrix-aligned groups 125 of three pixel elements, a first pixel element 126 being suitable for emitting green light, a second pixel element 127 being suitable for emitting red light and a third pixel element 128 being suitable for emitting blue light.

The support 110 with groups 125 pixel elements 126, 127 and 128 mounted on it, optionally is mounted in a frame part 130. The frame part 130 forms an elevated collar around the support 110. The display panel further optionally comprise a shader device 190. The shader device optionally comprises walls 191 defining cells 192, each cell 192 encompassing one group 125 of pixel elements. Each volume defined by the support 110 and four walls 191 or by three or two walls 191 of the shader device 190 and the frame part 130, may be filled with substantially transparent material 150. This material may be a potting material such as substantially transparent or translucent polyurethane or silicone. The pixel elements 126, 127 and 128 of each group 125 of pixel elements are embedded in, and their light emitting surfaces 121, 122 respectively 123 are covered with substantially transparent material 150. An optical surface 160 per cell 192 may be provided as a substantially flat surface, however may be curved as well, for example to create a lens-effect.

The substantially transparent material 150 covers the light emitting surfaces 121, 122 respectively 123 of the pixel elements 126, 127 respectively 128 and the support 110 thereby providing the optical surface 160 of the display panel 101.

For the particular example shown in Fig. 3a, the present invention not being limited thereto, the optical surface 160 of each cell 192 comprises a three pixel element zones 211, 212 and 213, one for each pixel element 126, 127 respectively 128. A support zone 220 encompasses the pixel element zones 211, 212 and 213. As shown in the cross section according to the plane AA' in Fig. 3b, a pixel element zone 211, 212 or 213 is a part of the optical surface 160 bound by the projection of a light emitting surface of one of the pixel elements 126, 127, respectively 128 onto the optical surface 160 in a direction 250 perpendicular to the optical surface 160. A support zone 220 is a part of the optical surface 160 bound by the projection of the support 110 onto the optical surface 160 in a direction 250 perpendicular to the optical surface 160.

The substantially transparent or translucent material 150 of the optical surface 160 along an encompassing zone 260, encompassing the pixel element zones 211, 212 and 213, and further comprising a part 219 of the support zone 220 of the optical surface, may be made more rough than the substantially transparent or translucent material 150 of the optical surface 160 of the remaining part 218 of the support zone 220 of the optical surface 160.

Turning to figures 3a and 3b, the display panel of the example shown is a multicolour display panel comprising a plurality of groups of LEDs 126, 127 and 128, which groups are positioned according to a regular array having a pitch P of e.g. 4.5 mm. The pitch is the average centre-to-centre distance of the geometric centres of adjacent groups 125 of pixel elements.

In the present example, the accumulated surface of the pixel element zones represents about 50% of the optical surface.

It is understood that alternatively the complete optical surface 160, i.e. the pixel element zones and the support zone, may be roughened for each optical surface 160.

It is understood that similar roughening patterns may be used as were disclosed in relation to the display panel 100 of Figure 1, and as shown in Figure 2.

It is further understood that many alternative display panels may be provided according to the present invention, such as a display panel according to Figure 1, in which the groups 125 of pixel elements 126, 127 and 128 are used instead of the pixel element 120, or a display panel according to Figure 2, in which pixel elements 120 are used instead of the groups 125 of pixel elements 126, 127 and 128.

In a particular example, the substantially transparent or translucent material is not a potting material but a capping material or lens material. In such embodiments the surface roughness of individual pixel elements, e.g. leds, may be modified. The latter may be performed by modifying the roughness of a capping element or lens element above the light emitting surface. Similar modifications as set out for the potting material may be obtained. If the individual pixel element is mounted on a support, the method also may comprise modifying a substantially transparent or translucent material above a portion of a support where no light emitting surface is present. Modification of the surface roughness for individual pixel elements may be performed easily in this way. The latter is illustrated by way of example for two individual led elements in FIG. 3c and FIG. 3d, indicating a substantially transparent or translucent material being a cap (FIG. 3c) or a lens (FIG. 3d).

In another aspect, the present invention relates to a method for providing at least one display or lighting element. Such a method may relate to providing a display panel, an individual display or lighting element such as for example a led, a set of display or lighting elements, a set of display or lighting elements mounted on a support, etc. The method comprises the steps of providing at least one pixel element for producing or controlling light whereby the at least one pixel element has a light emitting surface and has a substantially transparent material at least above the light emitting surface. The substantially transparent material may be capping material of a cap being present or lens material of a lens being present. The substantially transparent material also may be a potting material which may be present, or according to an embodiment of the present invention, may be provided. The method also comprises the step of modifying the roughness of the substantially transparent material, i.e. potting material, capping material or lens material, so as to decrease the reflectivity of the substantially transparent material above the light emitting surface. By way of illustration, the present invention not being limited thereto, a number of examples is provided.

In one example, a support 110 is provided on which a plurality of pixel elements 120, e.g. LEDs, are present or may be positioned. The support 110 may be mounted, e.g. fixed, in a frame part 130. Substantially transparent materials material 150 is provided on and between the pixel elements 120. In one example this may be provided in a volume defined by the elevated collar around the support 110 provided by the frame part 130. The substantially transparent material 150 can be provide in any suitable way. Usually the substantially transparent material is provided as a liquid, which is to be hardened or cured. The substantially transparent material defines now an optical surface 160 of the display panel 100.

In a next step, the roughness of the substantially transparent or translucent material of the optical surface along the pixel element zone and optionally along part of the complete support zone of the optical surface is modified for rendering the substantially transparent or translucent material of the optical surface along the pixel element zones of the optical surface less reflective and optionally more rough than the substantially transparent or translucent material of the optical surface along at least another part of the support zone of the optical surface.

In the embodiments as shown in Figure 1 a and Figure 1b, and Figure 3a and Figure 3b, at least the pixel element zones of the optical surface 160 of the display panel 100, are roughened. This may be done by irradiating the optical surface of the intermediate part 101 with a laser, e.g. a gas laser, preferably a CO₂-laser such as a 30 Watt laser marker. The roughening can be done by providing the regular or irregular pattern to the pixel element zones of the optical surface, of which some examples are shown in Figure 2. Laser methods and equipment for roughening or etching polymeric surfaces are known to the skilled person, e.g. from standard works such as "Lasers in Surface Engineering", ed. N. B. Dahotre, vol.1, ASM International, 1998, especially chapter 8, "Lasers for polymeric coatings" and more especially the section on "Laser induced etching of Polymeric materials".

It is understood that as such many different display panels for many different purposes, preferably for outdoor use, may be provided. The display panel, e.g. display panel 100, may be part of a power LED panel or may be part of a signal, such as a traffic signal. The display panel 100 may be part of a lighting apparatus or of a display such as a display of a display assembly.

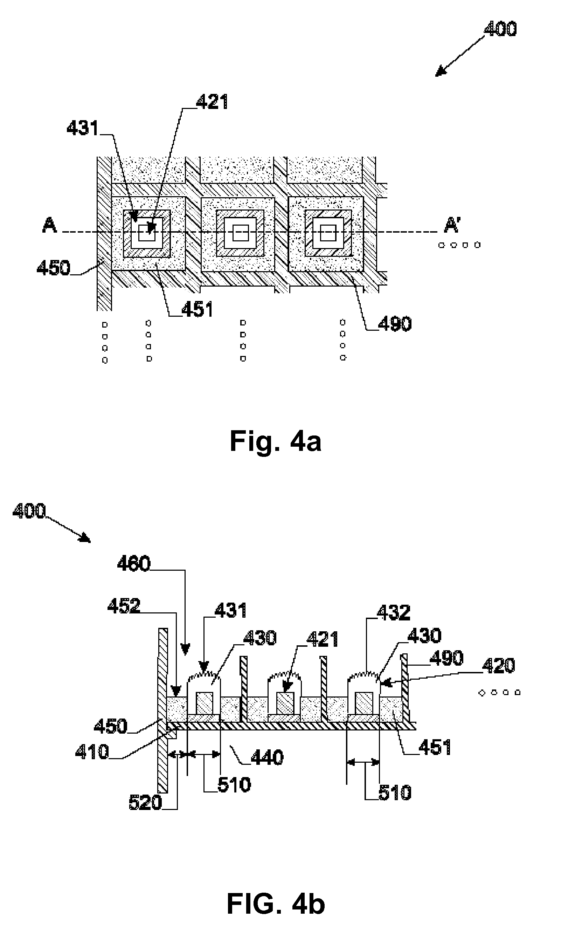

In another example, the method is applied to a display or display assembly. A display or display assembly may comprise a display panel 400 as shown in Figure 4a and Figure 4b. The display panel, shown by way of example, comprises a plurality of matrix-aligned pixel elements 420 for producing or controlling light. In this particular embodiment LED's are mounted. The present invention may be used with any suitable pixel element, e.g. an LCD pixel element, an EL pixel element, Plasma pixel element, an OLED pixel element, etc.

In some embodiments of the present invention, each pixel element 420 may be a light emitting element having light emitter 421. The light emitter is covered with a substantially transparent material 430, which may form a capping portion 432 having an outer surface 431 The outer surface 431 hence provides the light emitting surface of the light emitting element. The outer surface 431 is roughened for reducing the reflectivity of the light emitting element. This roughening may be done in an identical or similar way as set out above in relation to the embodiments shown in Figures 1a, figure 1b, Figure 2, Figure 3a and/or Figure 3b.

In embodiments of the present invention, the pixel elements 420 may be mounted on a carrying plate 440, which on its turn is mounted on a support 410, being e.g. a PCB board to which the pixel elements 420 are coupled.

The support 410, with mounted pixel elements 420, may be mounted in a frame part 450. In some embodiments, the frame part 450 forms an elevated collar around the support 410. The volume defined by the frame part 450 and support 410 may be filled with additional filling material 451, e.g. such that the outer surfaces of the light emitting elements protrude above the surface of the additional filling material. This material may be a potting material such as polyurethane or silicone. Alternatively filling material may just be provided in between the light emitting elements, without a collar being present.

The display panel may further comprise a shader device 490, which in this embodiment is embedded in the potting material as well. Alternatively, such a shader device may be not embedded by potting material.

As shown in Fig. 4a, the display panel imaging surface 460 may comprise a plurality of pixel element zones 510, one for each pixel element 420. A support zone 520 encompasses the pixel element zones 510. As shown in the cross-section according to the plane AA' in Fig. 4b, a pixel element zone 510 is a part of the optical surface 460 defined by the outer surfaces 431 of the capping portions 432. A support zone 520 is a part of the optical surface adjacent to and encompassing the capping portions.

The light emitting elements may be mount non-perpendicularly to the display panel imaging surface, but may be oriented under a small angle vis-à-vis the direction perpendicular to the display panel imaging surface, towards a given intended observation direction. This to improve the visibility of the image to be displayed on the display panel in case the images are intended to be observed under the observation direction.

The substantially transparent or translucent material 430 of the outer surface 431 is modified, in this case made rougher. After mounting the light emitting elements on the support 410, and after providing potting material 451, the surface 452 of the potting material may be modified as well, e.g. made rough.

In the example of the display panel as shown in figure 4a and 4b, a mono-colored display element is provided. It is understood that the light emitting elements may be replaced by a plurality, e.g. three light emitting elements similar as in figures 3a and 3b, for providing a multicolor display element.

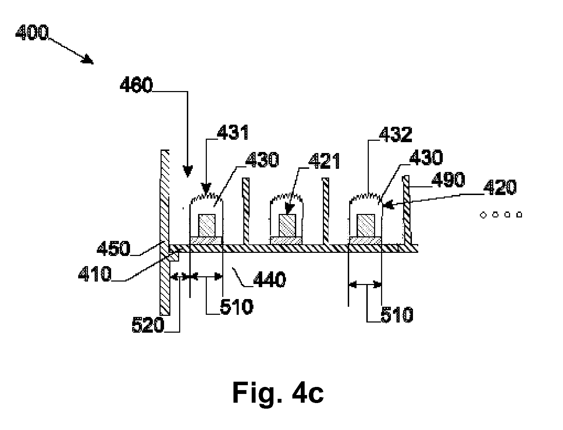

In a further example, the additional potting material may not be present and only the capping material or lens material above the light emitting surfaces are modified in roughness. The latter is illustrated in Fig. 4c.

In another example, the method comprises modifying the roughness of individually provided lighting or displaying elements, not mounted on a support. Such lighting or displaying elements may comprise a light emitting surface and a substantially transparent material on top thereof, e.g. in the form of a cap or lens. The surface of the cap or lens then may be modified in roughness. The latter may be performed in a similar way as set out above. In particular embodiments, single lighting or display elements may be modified, such as for example a led.

In another aspect, the present invention relates to a lighting and/or displaying element or system comprising at least one light source with a light emitting surface and a first encapsulant material. The first encapsulant material may be the original encapsulation material. Such a light source may be a light emitting device, such as e.g. a light emitting diode. The light source may comprise different segments for emitting different coloured light, such as for example a set of primary colours like red green and blue subpixels, although the invention is not limited thereto. The light emitting surface may be part of a light emitting diode comprising a plurality, e.g. three, sub-pixels in the same LED packaging. The sub-pixels may be red, green and blue subpixels within the same LED packaging. The sub-pixels may be positioned in any suitable way such as in parallel next to each other, e.g. ordered in column or in row or in matrix. If e.g. three sub-pixels are used, the sub-pixels may be in a triangular shaped position, i.e. each sub-pixel roughly corresponding with the angles of a triangle. Such light sources e.g. light emitting devices, thus advantageously are adapted for emitting full colour. The light source may comprise a plurality of light emitting parts, each emitting light of a particular colour, although the invention is not limited thereto. The first aspect also relates to such a light source comprising first encapsulant material, e.g. for use in a lighting, imaging and/or displaying system. According to the present invention, the first encapsulant material is such that the encapsulation surface of the light source is not flat. It may have a concave surface. The encapsulant material may be material having a large shrink when solidified and/or having large thermal expansion coefficient at the solidification point. It may be larger than that of epoxy, although the invention is not limited thereto. Embodiments of the present invention is especially suitable for materials showing a large shrink, as the deviation from a flat surface and the corresponding optical effects on the emitted light will be largest for such materials, but the invention is not limited thereto. Embodiments of the present invention may be suitable for all first encapsulation materials having a non flat surface after solidification at the light source and therefore influencing the optical outcoupling. One particular example of such an encapsulant material may be silicone. Silicones may for example comprise mixed inorganic-organic polymers with the chemical formula [R₂SiO]ₙ, where R are organic groups such as for example methyl, ethyl, and phenyl. These materials may consist of an inorganic silicon-oxygen backbone (...-Si-O-Si-O-Si-O-...) with organic side groups attached to the silicon atoms, which are four-coordinate. In some silicones organic side groups may be used to link two or more of these -Si-O- backbones together. By varying the -Si-O-chain lengths, side groups, and crosslinking, silicones can be synthesized with a wide variety of properties and compositions. It may be silicone materials is based on silicone resins, which are formed by branched and cage-like oligosiloxanes. The silicone may be a polymerised siloxane or polysiloxane.

According to embodiments of the present invention the light sources furthermore comprise a second encapsulant material, which can also be referred to as additional encapsulant material and is provided so as to alter or modify the free surface of the encapsulation, i.e. the surface of the encapsulation through which light outcoupling from the light source occurs. This second encapsulant material may be the same material as the first encapsulant material, although the invention is not limited thereto. This second encapsulant material may be a different material. The modified surface may be a substantially flat surface or it may have a different predetermined shape, e.g. for tuning optical properties of the emission from the light source, e.g. as function of the viewing angle.

In still a further aspect, the present invention relates to a method for adjusting a light emitting device, such as e.g. a light emitting diode, or a display system comprising at least one light emitting device, such as e.g. a light emitting diode. The method comprises obtaining a light source with first encapsulation material for encapsulating the light emitting surfaces, such as e.g. a light emitting device like for example a light emitting diode. The light source, e.g. light emitting device, preferably is adapted for emitting full colour. The light source may comprise a plurality of light emitting parts, each emitting light of a particular colour, although the invention is not limited thereto. The first encapsulation material thereby is such that the encapsulation surface of the light source is not flat. It may have a concave surface. The surface may be such that the optical outcoupling is substantially influenced by the surface, resulting in a large viewing angle dependency of optical properties of the emitted light, such as e.g. colour and/or light intensity. The method is especially suitable for encapsulation materials having a large shrink when solidified and/or large thermal expansion coefficient at the solidification coefficient. These may be larger than for epoxy. The encapsulant material may be material having a lower viscosity than epoxy. In one particular example, the encapsulant material may be silicone. Silicones may for example comprise mixed inorganic-organic polymers with the chemical formula [R₂SiO]ₙ, where R are organic groups such as for example methyl, ethyl, and phenyl. These materials may consist of an inorganic silicon-oxygen backbone (...-Si-O-Si-O-Si-O-...) with organic side groups attached to the silicon atoms, which are four-coordinate. In some silicones organic side groups may be used to link two or more of these -Si-O- backbones together. By varying the -Si-O- chain lengths, side groups, and crosslinking, silicones can be synthesized with a wide variety of properties and compositions. It may be silicone materials is based on silicone resins, which are formed by branched and cage-like oligosiloxanes. The silicone may be a polymerised siloxane or polysiloxane.

The method further comprises providing on the light source, e.g. light emitting device, second encapsulation material, which may be referred to as additional encapsulation material. Such second encapsulation material may be provided on top of the original encapsulation material. It may be the same material or a different material. It also may be a silicone material. Providing second encapsulation material may comprise providing second encapsulation material so as to alter or modify the surface of the encapsulation through which light outcoupling occurs. The method may comprise tuning the surface of the encapsulation through which light outcoupling occurs to optimise optical properties, e.g. as function of viewing angle. The latter may be performed by controlling the amount of additional material used. The latter additionally may be performed by controlling its application on the light source and the environmental parameters such as temperature. Providing second encapsulation material may be such that the surface through which the light is coupled out of the package of the light source is substantially flat.

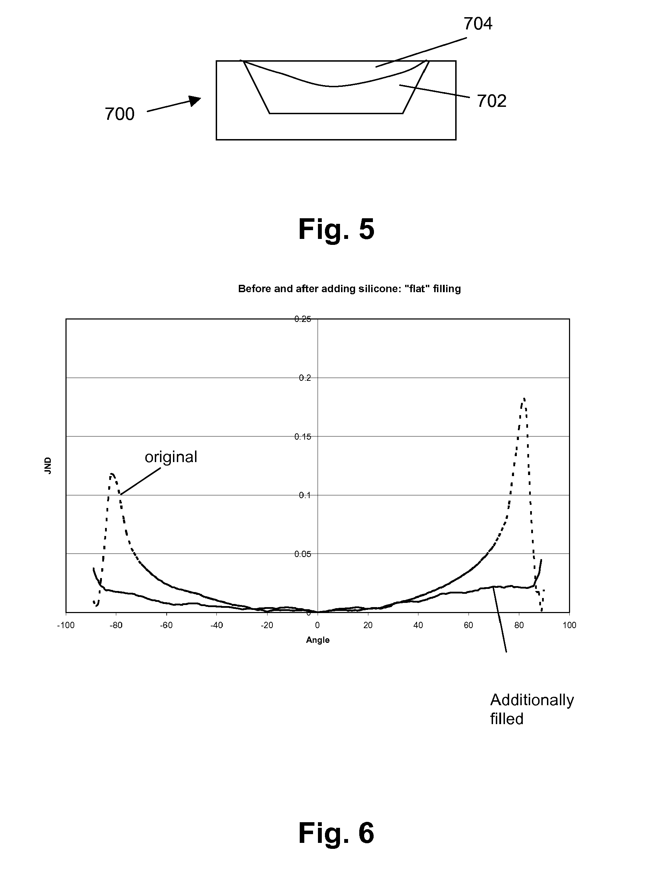

It is an advantage of embodiments of the present invention that the method provides fine tuning the viewing angle by filling the light source, e.g. light emitting device 700 (LED), initially filled with a first encapsulation material 702, also referred to as first filling material, with second, e.g. additional, encapsulation material 704, e.g. extra silicone, in order to get a modified surface of the encapsulation, also referred to as filling material. Such a modified surface, may be a flat surface and thus form a flat lens, such as e.g. a flat silicone "lens".It also may have another surface shape tuned to optimise optical properties such as colour e.g. as function of the viewing angle. Such first encapsulation material 702 and additional encapsulation material 704 is by way of example illustrated in Fig. 5.

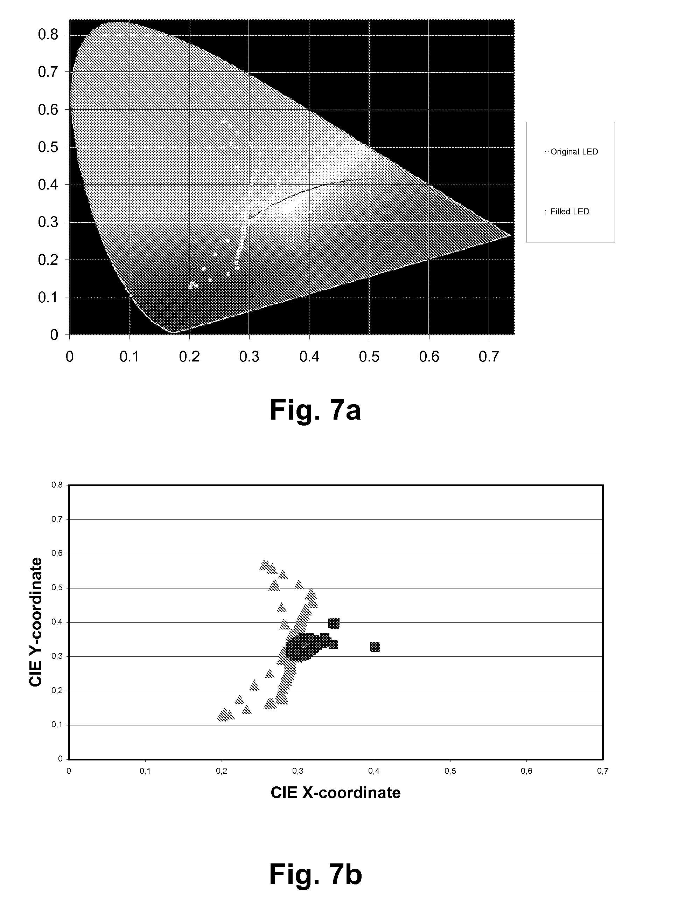

In one example, a led with a concave silicone lens was measured and compared to the same led which was later filled with extra silicone. In order to quantify the color shift with increasing viewing angle, the Just Noticeable Difference (JND) was calculated compared to the center x and y value of the white color. The Just Noticeable Difference thereby is the difference in optical property that the average human observer can just perceive at a specified luminance level and viewing conditions. The JND is shown in FIG. 6 for both the originally filled and additionally filled LED: In the original LED, a big color shift is visible from +50° onwards on the right and from -50° onwards to the left. This is seriously reduced when adding the extra filling. This is even more visible when the x and y color coordinates are filled in in a color diagram, as shown in Fig. 7a and Fig. 7b. For the original LED (shown in Fig. 7b by triangles), the color shifts from green on the left side of the display towards blue to the right angle. This shift is enormously reduced when providing additional encapsulation material for the light source, e.g. by filling the led with silicone (shown in Fig. 7b by squares). Evaluation also can be made based on the colour difference that occurs, expressed as a distance in the u'v' colour space.

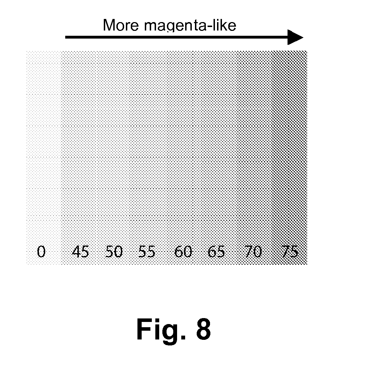

By way of example, the present invention not being limited thereto, some pictures of what the viewer is actually seeing under different viewing angles for a white image are shown. In Fig. 8, a white image as perceived by a viewer is shown. In front of the display, the perceived image is white, but with increasing viewing angle (increasing from 0° to 75°), the colour of the image is turning more and more magenta.

It is to be noticed that the features of the lighting and/or displaying elements may be applied mutates mutandis to the features of the lighting and/or displaying elements of the other aspects of the present invention. For example, the lighting and/or displaying elements with modified roughness of the substantially transpararent material may be lighting and/or display elements as described in the last two aspects, whereby the substantially transparent material is the first or second encapsulant material. Other features and advantages of the lighting and/or display elements as described in the last two aspects also may apply to the first aspects of the present invention.

It is to be understood that although preferred embodiments, specific constructions and configurations, as well as materials, have been discussed herein for devices according to the present invention, various changes or modifications in form and detail may be made without departing from the scope and spirit of this invention. Operations may be interchanged among functional blocks. Steps may be added or deleted.

## Claims

1. A method for providing at least one display or lighting element (100), the method comprising the steps of
- providing at least one pixel element (120) for producing or controlling light, the pixel element (120) having a light emitting surface (121) and having a substantially transparent material (150) at least above the light emitting surface (121), and
- modifying the roughness of the substantially transparent material (150) so as to decrease the reflectivity of the substantially transparent material (150) above the light emitting surface (121).

2. A method according to claim 1, wherein providing at least one pixel element (120) comprises providing the at least one pixel element (120) so that it is mounted on a support (110), wherein the display or lighting element furthermore comprises a substantially transparent material (150) also over at least a part of the support (110) thereby providing an optical surface (160) having at least one pixel element zone (220) and at least one support zone (210), wherein the pixel element zone (220) is a part of the optical surface (160) above the light emitting surface (121) and the support zone (210) is a part of the optical surface (160) not above a light emitting surface (121) and wherein modifying the roughness of the substantially transparent material (150) is adapted for rendering the pixel element zone (220) of the optical surface (160) equally or more rough than the support zone (210) of the optical surface (160).

3. A method according to claim 2, whereby the method furthermore comprises the step of modifying the roughness of the substantially transparent material (150) in the support zone (220).

4. A method according to any of claims 1 to 3, wherein the step of modifying the roughness of the substantially transparent material (150) comprises the step of roughening the substantially transparent material (150).

5. A method according to claim 4, wherein the roughening comprises removing a part of the substantially transparent material (150) thereby providing a regular or irregular surface pattern.

6. A method according to claim 5, wherein removing a part of the substantially transparent material (150) comprises irradiating the substantially transparent material (150) at the optical surface (160) with a laser.

7. A method according to claim 6, wherein radiation of a CO₂-laser is used to irradiate the substantially transparent material at the optical surface (160).

8. A method according to any one of the claims 1 to 7, wherein the substantially transparent material (150) is a potting material selected out of the group of polyurethane polymers, silicone-based materials, epoxy resin and acrylate polymers.

9. A display or lighting element (100) comprising at least one pixel element (120) for producing or controlling light, the pixel element (120) having a light emitting surface (121), the display or lighting element (100) furthermore comprising a substantially transparent material (150) above at least the light emitting surface (121), wherein the substantially transparent material (150) has a modified roughness so as to decrease the reflectivity of the substantially transparent material (150) above the light emitting surface (121).

10. A display or lighting element (100) according to claim 9, the display or lighting element (100) furthermore comprising a support (110) for supporting the at least one pixel element (120), wherein the substantially transparent material (150) also is provided over the support (110) thereby providing an optical surface (160) having at least one pixel element zone (220) and at least one support zone (210), wherein the pixel element zone (220) is a part of the optical surface (160) above the light emitting surface (121) and the support zone (210) is a part of the optical surface (160) not above a light emitting surface (121) and wherein said substantially transparent material (150) has a modified roughness adapted for rendering the substantially transparent material (150) in the pixel element zone (220) equally or more rough than the substantially transparent material in the support zone (210).

11. A display or lighting element (100) according to any of claims 9 to 10, wherein the substantially transparent material (150) is roughened.

12. A display or lighting element (100) according to any one of the claims 9 to 11, wherein the substantially transparent material (150) is roughened by providing a regular pattern to the substantially transparent material (150).

13. A display or lighting element (100) according to any one of the claims 9 to 12, wherein the at least one pixel element (120) is at least one LED.

14. A display or lighting element (100) according to any one of the claims 9 to 13, wherein the substantially transparent material (150) is a potting material.

15. A display or lighting element (100) according to any one of the claims 9 to 14, wherein the display or lighting element (100) is any of an outdoor display panel, a traffic signal or traffic lights, a lighting apparatus or a display.
